# EUROPEAN PATENT SPECIFICATION

(11) **EP 2 425 744 B1**
(45) Date of publication and mention of the grant of the patent: **30.09.2015**
(21) Application number: 11175300.0
(22) Date of filing: 26.07.2011
(51) Int. Cl.: A47B 88/04, H05K 7/14

(54) **Mounting bracket**
Montageklammer
Support de montage

(30) Priority: 03.09.2010 TW 099130010
(43) Date of publication of application: 07.03.2012
(73) Proprietor: King Slide Works Co., Ltd., Kaohsiung City (TW)
(72) Inventor: Chen, Ken-Ching, Kaohsiung City (TW); Tseng, I-Ming, Kaohsiung City (TW); Wang, Chun-Chiang, Kaohsiung City (TW)
(74) Representative: Viering, Jentschura & Partner Patent- und Rechtsanwälte

(56) References cited:
- US-A1- 2008 073 469
- US-A1- 2009 114 785

## Description

### FIELD OF THE INVENTION

The present invention relates to a mounting bracket, and more particularly, to a mounting bracket which is connected to a rail and adjustably connected to a support column of an equipment rack by a pin assembly of the mounting bracket.

### BACKGROUND OF THE INVENTION

U.S. Patent No. 7,694,926 to Allen et al discloses a mounting bracket 200 which includes a base member 202 with a side plate 204 and an end plate 206 connected to the side plate 204. Two pins 210 are connected to the end plate 206. A four-rack equipment rack 100 includes four vertical support columns 104 which are arranged as a square and each vertical support column 104 includes a plurality of holes 208. When assembling, two mounting brackets are respectively connected to two ends of the rail and each mounting bracket has two pins which extend through the holes in the vertical support columns of the equipment rack, such that the rail is connected to the equipment rack. When the two rails are correspondingly connected to the equipment rack, a rack-mount module 102 can be attached to the rails and pulled out from the equipment rack or received in the equipment rack.

However, when the distance between the holes in the vertical support columns on two sides of the equipment rack includes a larger tolerance which causes the combination width of the mounting brackets, rails and rack-mount module cannot match with the real distance, because the pins on the mounting brackets are engaged with the holes in the vertical support columns of the equipment rack with only very small gap which is not allowed to be adjusted in a lateral direction. Therefore, the installation is difficult and even cannot be finished. The rails will have significant resistance even drop from the equipment rack. Besides, when rack-mount module has small tolerance, the pins on the mounting brackets cannot be properly adjusted to complete the installation.

Furthermore, U.S. Patent Nos. 7,744,177, 6,840,388, 6,830,300, 6,702,124, US 2008/0073469 and 6,659,577 disclose the pins cooperated with the mounting brackets and all of the prior patents are cited for reference.

The present invention intends to provide a mounting bracket which improves the shortcomings of the conventional mounting brackets.

### SUMMARY OF THE INVENTION

The present invention relates to a mounting bracket which comprises a side plate and an end plate extending perpendicularly from an end of the side plate. The end plate has an elongate hole. A pin assembly comprises a pin, a protrusion and a fixing member, wherein the pin has a connection hole. The protrusion is located corresponding to the elongate hole of the end plate and the thickness of the protrusion is larger than that of the end plate. The fixing member has a head and a shank extending from the head. The head of the fixing member and the pin are longitudinally located on two sides of the end plate. The shank is connected to the connection hole of the pin and the protrusion is located between the head of the fixing member and the pin. The protrusion is movable within elongate hole of the end plate.

Preferably, the protrusion extends from an end of the pin.

Preferably, the mounting bracket further comprises a connection plate and at least two pins connected to the connection plate.

Preferably, the protrusion has a hole which is located corresponding to the connection hole of the pin.

Preferably, the protrusion is integrally connected with the fixing member and extends from the head of the fixing member.

Preferably, the periphery of the head of the fixing member extends beyond the elongate hole of the end plate.

Preferably, the fixing member includes a washer whose periphery extends beyond the elongate hole of the end plate.

The primary object of the present invention is to provide a mounting bracket which has at least one pin that is transversely adjustable so as to be easily installed to an equipment rack.

The present invention will become more obvious from the following description when taken in connection with the accompanying drawings which show, for purposes of illustration only, a preferred embodiment in accordance with the present invention.

### BRIEF DESCRIPTION OF THE DRAWINGS

Fig. 1 is an exploded view to show the mounting bracket of the present invention;
Fig. 2 is an exploded view to show that the pin assembly of the mounting bracket of the present invention includes a connection plate;
Fig. 3 is an exploded view to show the mounting bracket of the present invention and a vertical support column;
Fig. 4 is a cross sectional view to show that the mounting bracket is connected to the vertical support column;
Fig. 5 shows the adjusted status related to the mounting bracket and the vertical support column;
Fig. 6 shows the second embodiment of the pin assembly of the present invention;
Fig. 7 shows the third embodiment of the pin assembly of the present invention;
Fig. 8 shows the fourth embodiment of the pin assembly of the present invention;
Fig. 9 shows the fifth embodiment of the pin assembly of the present invention, and
Fig. 10 shows the sixth embodiment of the pin assembly of the present invention.

### DETAILED DESCRIPTION OF THE PREFERRED EMBODIMENT

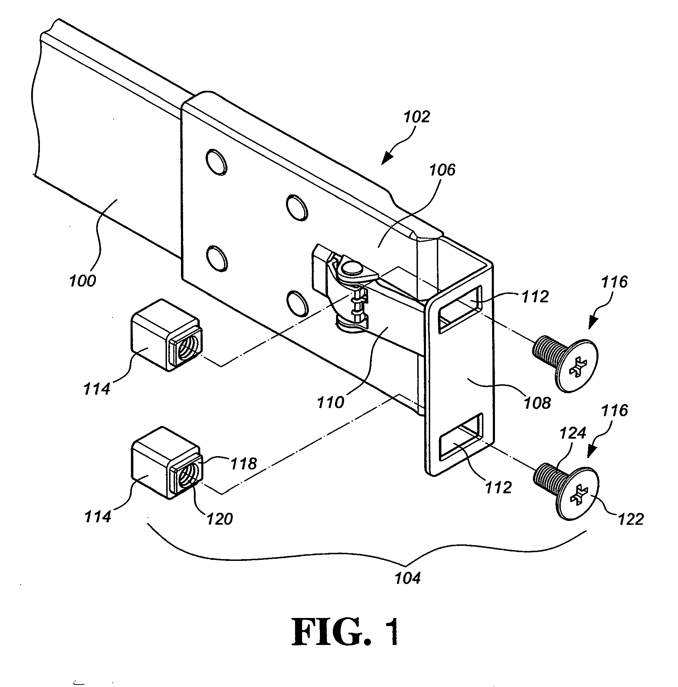

Referring to Fig. 1, the first embodiment of the present invention comprises a rail 100, a mounting bracket 102 connected to an end of the rail 100, and a pin assembly 104 connected to the mounting bracket 102. The mounting bracket 102 comprises a side plate 106 and an end plate 108 extending substantially perpendicularly from an end of the side plate 106. A stop 110 is connected to the side plate 106 of the mounting bracket 102 and extends toward the end plate 108. The side plate 106 is connected to the rail 100 and the end plate 108 has two elongate holes 112. The pin assembly 104 comprises two sets of parts so as to be located corresponding to the two elongate holes 112 of the end plate 108. Each set of parts comprises a pin 114, a fixing member 116 and a protrusion 118 located between the pin 114 and the fixing member 116. The pin 114 has a connection hole 120 such as a threaded hole. The fixing member 116 comprises a head 122 and a shank 124 extending from the head 122. The head 122 has a recess such as a Phillips recess or a cabinet recess for a screw driver to be engaged therewith. The shank 124 can be a threaded shank so as to be connected to the connection hole 120 of the pin 114. The protrusion 118 is located corresponding to the connection hole 120 of the pin 114 and forms a rectangular body. In this embodiment, the protrusion 118 extends from an end of the pin 114.

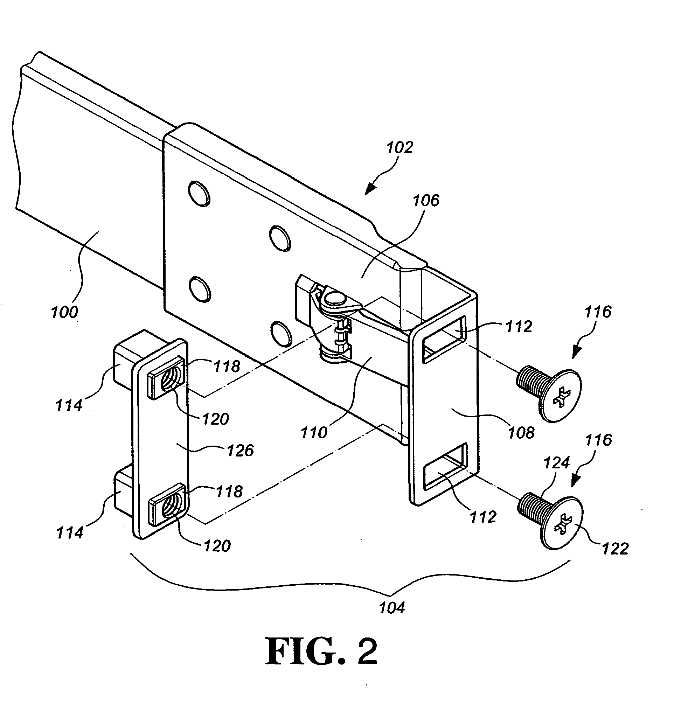

Fig. 2 shows that a connection plate 126 is connected between the two pins 114 to form an integral part. In this embodiment, the two pins 114, the two protrusions 118 and the connection plate 126 are integrally formed as a one piece.

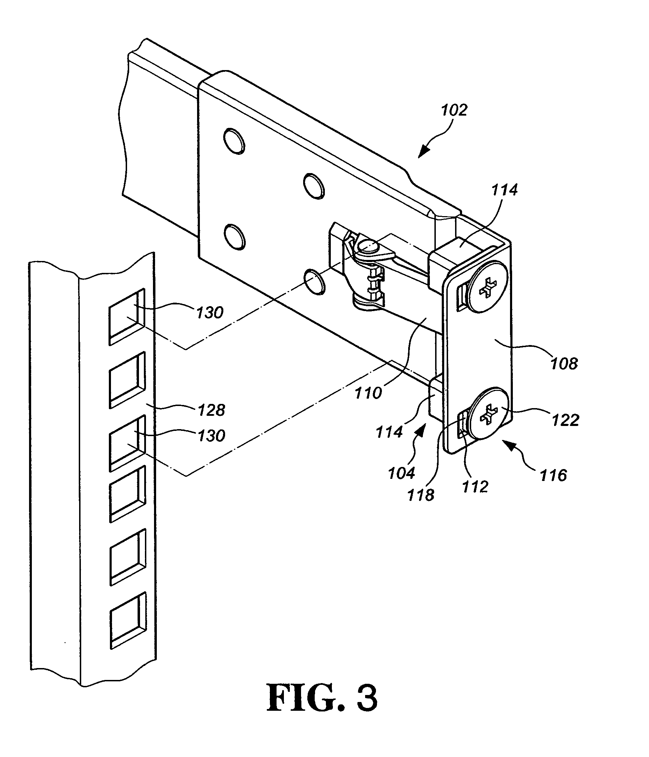

Fig. 3 shows the combination of the pin assembly 104, wherein the pin 114 and the fixing member 116 are longitudinally located on two sides of the end plate 108. The protrusion 118 is located within the elongate hole 112 of the end plate 108 and connected to the pin 114 by the fixing member 116. The protrusion 118 is located between the head 122 of the fixing member 116 and the pin 114. The periphery of the head 122 of the fixing member 116 extends beyond the elongate hole 112 of the end plate 108. A vertical support column 128 has a plurality of holes 130. When the pin assembly 104 is connected to the vertical support column 128, the two pins 114 of the pin assembly 104 are located corresponding to the two holes 130 of the vertical support column 128.

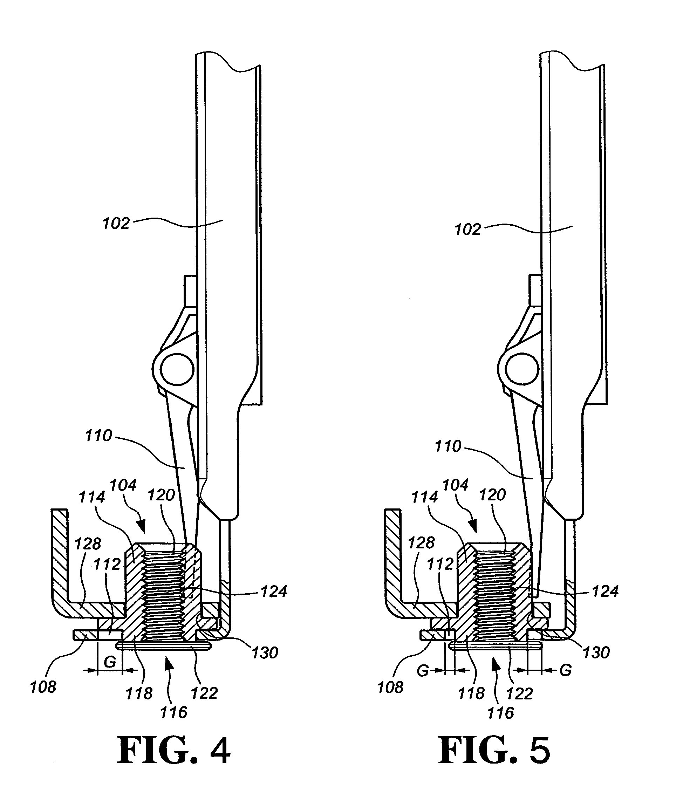

Fig. 4 further discloses the pin assembly 104 is connected to the holes 130 of the vertical support column 128 by the pins 114. By the contact between the stop 110 on the mounting bracket 102 and the vertical support column 128, the pin 114 cannot be disengaged from the hole 130 of the vertical support column 128 in a longitudinal direction. The pin assembly 104 is engaged with the elongate hole 112 of the end plate 108 of the mounting bracket 102 by the protrusion 118, and the elongate hole 112 provides a space "G" for transverse movement of the protrusion 118 in the elongate hole 112. The thickness of the protrusion 118 is larger than that of the end plate 108. Therefore, when the shank 124 passes through the protrusion 118 and is connected to the connection hole 120 of the pin 114, the head 122 of the fixing member 116 is in contact with the stop 118 and does not contact the end plate 108 so as to ensure that the pin 114 is movable in the elongate hole 112 of the end plate 108 by the protrusion 118.

The pin 114 of the pin assembly 104 is engaged with the hole 130 of the vertical support column 128 and only very small gap is provided, so that we assume there is no relative shaft between the pin 114 and the hole 130. As shown in Fig. 5, the pin assembly 104 has a special feature, when the vertical support column 128 is stationary and assumes as a base, the pin 114 engaged with the hole 130 of the vertical support column 128 is stationary. The rail 100 and the mounting bracket 102 can be properly adjusted by the space "G" between the elongate hole 112 of the end plate 108 and the protrusion 118. Similarly, when the rail 100 and the mounting bracket 102 are assumed to be stationary base, if the vertical support column 128 slightly shifts, by the pin 114 being movable in the elongate hole 112 of the end plate 108 by the protrusion 118 to ensure that the pin 114 is engaged with the hole 130 of the vertical support column 128.

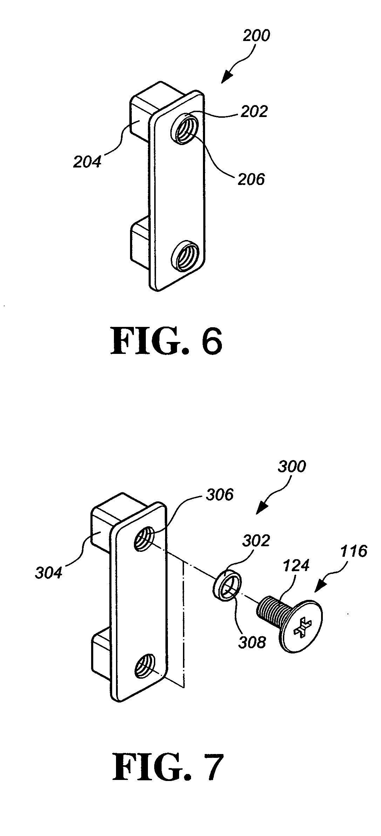

Fig. 6 shows that the protrusion 202 of the pin assembly 200 is a cylindrical member which extends from an end of the pin 204 and is located corresponding to the connection hole 206.

Fig. 7 shows that the pin assembly 300 includes two individual protrusion 302 and pin 304, the protrusion 302 has a hole 308 which is located corresponding to the connection hole 306 of the pin 304. The shank 124 of the fixing member 116 extends through the hole 308 of the protrusion 302 and is connected to the connection hole 306 of the pin 304.

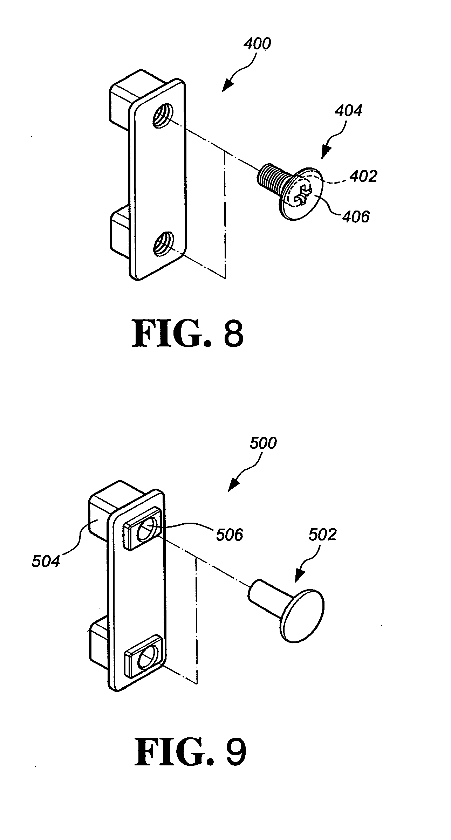

Fig. 8 shows that the protrusion 402 of the pin assembly 400 is integrally connected with the fixing member 404 and extends from the head 406 of the fixing member 404.

Fig. 9 shows that the fixing member 502 of the pin assembly 500 is a rivet which connects the pin 504 to the connection hole 506.

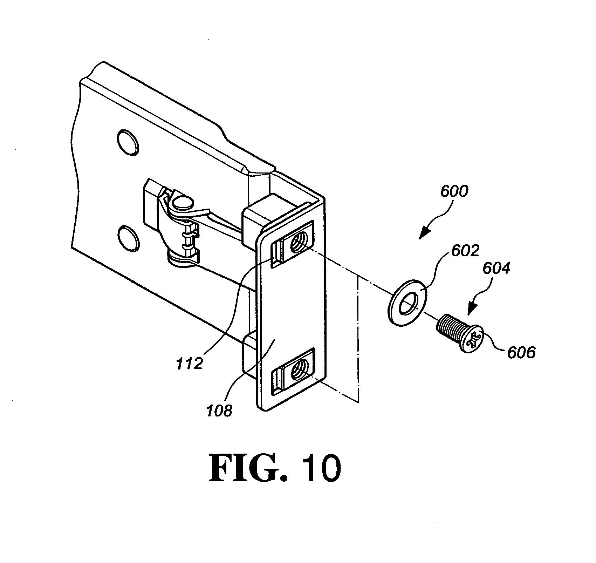

Fig. 10 shows that the pin assembly 600 includes a washer 602 connected to the fixing member 604 and the periphery of the washer 602 extends beyond the elongate hole 112 of the end plate 108. By the arrangement, even if the head 606 of the fixing member 604 is smaller, the head 606 can contact the end plate 108 of the mounting bracket 102 by the washer 602.

While we have shown and described the embodiment in accordance with the present invention, it should be clear to those skilled in the art that further embodiments may be made without departing from the scope of the present invention.

## Claims

1. A mounting bracket (102), comprising a side plate (106) and an end plate (108) extending perpendicularly from an end of the side plate (106), the end plate (108) having an elongate hole (112) and at least one pin assembly (104), comprising:
a pin (114) having a connection hole (120);
a protrusion (118) located corresponding to the elongate hole (112) of the end plate (108), a thickness of the protrusion (118) being larger than that of the end plate (108), and
a fixing member (116) having a head (122) and a shank (124) extending from the head (122),;
wherein the head (122) of the fixing member (116) and the pin (114) are longitudinally located on two sides of the end plate (108), the shank (124) of the fixing member (116) is connected to the connection hole (120) of the pin (114), the protrusion (118) is located between the head (122) of the fixing member (116) and the pin (114), **characterized in that**
the pin (114) is movable within the elongate hole (112) of the end plate (108), wherein the elongate hole (112) provides a space "G" for transverse movement of the pin (114) in the elongate hole (112) and wherein the head (122) of the fixing member (116) is in contact with the protrusion (118) and does not contact the end plate (108),

2. The mounting bracket as claimed in claim 1, wherein the protrusion (118) extends from an end of the pin (114).

3. The mounting bracket as claimed in claim 1, further comprising a connection plate (126) and at least two pins (114) are connected to the connection plate (126).

4. The mounting bracket as claimed in claim 1, wherein the protrusion (302) has a hole (308) which is located corresponding to the connection hole (306) of the pin (304).

5. The mounting bracket as claimed in claim 1, wherein the protrusion (402) is integrally connected with the fixing member (404) and extends from the head (406) of the fixing member (404).

6. The mounting bracket as claimed in claim 1, wherein a periphery of the head (122) of the fixing member (116) extends beyond the elongate hole (112) of the end plate (108).

7. The mounting bracket as claimed in claim 1, wherein the fixing member (604) includes a washer (602) whose periphery extends beyond the elongate hole (112) of the end plate (108).

## Patentansprüche

1. Ein Befestigungsbügel (102), bestehend aus einer Seitenplatte (106) und einer Endplatte (108), die sich senkrecht von einem Ende der Seitenplatte (106) erstreckt, wobei die Endplatte (108) ein Längsloch (112) aufweist und aus mindestens einer Stiftmontage (104) besteht, umfassend:
einem Stift (114) mit einem Verbindungsloch (120);
einem Vorsprung (118), der in Übereinstimmung mit dem Längsloch (112) der Endplatte (108) gebildet ist, wobei eine Dicke des Vorsprungs (118) größer als jene der Endplatte (108) ist, und
einer Befestigungsschraube (116) mit einem Kopf (122) und einem Schaft (124), der sich vom Kopf (122) erstreckt;
wobei der Kopf (122) der Befestigungsschraube (116) und der Stift (114) der Länge nach auf zwei Seiten der Endplatte (108) angeordnet sind; der Schaft (124) der Befestigungsschraube (116) am Verbindungsloch (120) des Stifts (114) befestigt ist; der Vorsprung (118) zwischen dem Kopf (122) der Befestigungsschraube (116) und dem Stift (114) angeordnet ist, **dadurch gekennzeichnet, dass**
der Stift (114) innerhalb des Längsloches (112) der Endplatte (108) beweglich ist, wobei das Längsloch (112) einen Raum "G" für die Querbewegung des Stifts (114) im Längsloch (112) aufweist und der Kopf (122) der Befestigungsschraube (116) mit dem Vorsprung (118) in Berührung steht und mit der Endplatte (108) nicht in Berührung kommt;

2. Der Befestigungsbügel nach Anspruch 1, wobei sich der Vorsprung (118) von einem Ende des Stifts (114) erstreckt.

3. Der Befestigungsbügel nach Anspruch 1, weiter bestehend aus einer Befestigungsplatte (126), wobei mindestens zwei Stifte (114) an der Befestigungsplatte (126) befestigt sind.

4. Der Befestigungsbügel nach Anspruch 1, wobei der Vorsprung (302) ein Loch (308) in Übereinstimmung mit dem Verbindungsloch (306) des Stiftes (304) aufweist.

5. Der Befestigungsbügel nach Anspruch 1, wobei der Vorsprung (402) einstückig mit der Befestigungsschraube (404) befestigt ist und sich vom Kopf (406) der Befestigungsschraube (404) ertsreclct.

6. Der Befestigungsbügel nach Anspruch 1, wobei sich eine Peripherie des Kopfes (122) der Befestigungsschraube (116) über das Längsloch (112) der Endplatte (108) hinaus erstreckt.

7. Der Befestigungsbügel nach Anspruch 1, wobei die Befestigungsschraube (604) aus einer Unterlegscheibe (602) besteht, deren Peripherie sich über das Längsloch (112) der Endplatte (108) hinaus erstreckt.

## Revendications

1. Un support de fixation (102), comprenant une plaque latérale (106) et une plaque d'extrémité (108) s'étendant de manière perpendiculaire à partir d'une extrémité de la plaque latérale (106), la plaque d'extrémité (108) ayant un trou oblong (112) et au moins un ensemble de goupilles (104), comprenant :
une goupille (114) ayant un trou de connexion (120) ;
une saillie (118) située en correspondance avec le trou oblong (112) de la plaque d'extrémité (108), une épaisseur de la saillie (118) étant supérieure à celle de de la plaque d'extrémité (108), et
un élément de fixation (116) ayant une tête (122) et une tige (124) s'étendant à partir de la tête (122), ;
dans lequel la tête (122) de l'élément de fixation (116) et la goupille (114) sont situées de manière longitudinale sur deux côtés de la plaque d'extrémité (108), la tige (124) de l'élément de fixation (116) est reliée au trou de connexion (120) de la goupille (114), la saillie (118) est située entre la tête (122) de l'élément de fixation (116) et la goupille (114), **caractérisé en ce que**
la goupille (114) est mobile dans le trou oblong (112) de la plaque d'extrémité (108), dans lequel le trou oblong (112) dispose d'un espace "G" pour le mouvement transversal de la goupille (114) dans le trou oblong (112) et dans lequel la tête (122) de l'élément de fixation (116) est en contact avec la saillie (118) et n'est pas en contact avec la plaque d'extrémité (108),

2. Le support de fixation selon la revendication 1, dans lequel la saillie (118) s'étend à partir d'une extrémité de la goupille (114).

3. Le support de fixation selon la revendication 1, comprenant en outre une plaque de connexion (126) et au moins deux goupilles (114) sont connectées à la plaque de connexion (126).

4. Le support de fixation selon la revendication 1, dans lequel la saillie (302) a un trou (308) qui est situé en correspondance avec le trou de connexion (306) de la goupille (304).

5. Le support de fixation selon la revendication 1, dans lequel la saillie (402) est intégralement reliée à l'élément de fixation (404) et s'étend à partir de la tête (406) de l'élément de fixation (404).

6. Le support de fixation selon la revendication 1, dans lequel une périphérie de la tête (122) de l'élément de fixation (116) s'étend au-delà du trou oblong (112) de la plaque d'extrémité (108).

7. Le support de fixation selon la revendication 1, dans lequel l'élément de fixation (604) comprend une rondelle (602) dont la périphérie s'étend au-delà du trou oblong (112) de la plaque d'extrémité (108).
